# EUROPÄISCHE PATENTSCHRIFT

(11) **EP 2 519 979 B1**
(45) Veröffentlichungstag und Bekanntmachung des Hinweises auf die Patenterteilung: **18.12.2019**
(21) Anmeldenummer: 10798083.1
(22) Anmeldetag: 20.12.2010
(51) Int. Cl.: H01L 33/00, H01L 33/32, H01L 33/38, H01L 33/22, H01L 33/16, H01L 33/12, H01L 33/14

(54) **OPTOELEKTRONISCHER HALBLEITERCHIP MIT ZWEI AUF ALGAN BASIERENDEN ZWISCHENSCHICHTEN**
OPTOELECTRONIC SEMICONDUCTOR CHIP HAVING TWO INTERMEDIATE LAYERS BASED ON ALGAN
PUCE SEMICONDUCTRICE OPTOÉLECTRONIQUE COMPRENANT DEUX COUCHES INTERMÉDIAIRES À BASE D'ALGAN

(30) Priorität: 30.12.2009 DE 102009060749
(43) Veröffentlichungstag der Anmeldung: 07.11.2012
(73) Patentinhaber: OSRAM Opto Semiconductors GmbH, 93055 Regensburg (DE)
(72) Erfinder: PETER, Matthias, 93055 Regensburg (DE); MEYER, Tobias, 93346 Ihrlerstein (DE); GMEINWIESER, Nikolaus, 93083 Obertraubling (DE); TAKI, Tetsuya, 155-0031 Tokyo (JP); LUGAUER, Hans-Jürgen, 93161 Sinzing (DE); WALTER, Alexander, 93164 Laaber (DE)
(74) Vertreter: Epping - Hermann - Fischer
(86) Internationale Anmeldenummer: PCT/EP2010/070274
(87) Internationale Veröffentlichungsnummer: WO 2011/080144

(56) Entgegenhaltungen:
- EP-A1- 2 019 437
- EP-A2- 1 505 698
- EP-A2- 1 814 164
- WO-A1-2005/036658
- WO-A1-2005/036658
- DE-A1-102007 057 241
- DE-A1-102008 011 848
- DE-A1-102008 011 848
- DE-A1-102008 032 318
- US-A- 6 121 638
- US-A- 6 121 638
- US-A- 6 147 364
- US-A1- 2002 110 945
- US-A1- 2003 230 754
- US-A1- 2003 230 754
- US-A1- 2009 283 787
- US-A1- 2009 283 787

## Beschreibung

Es wird ein optoelektronischer Halbleiterchip mit auf AlGaN basierenden Zwischenschichten angegeben.

Die Druckschrift EP 1 505 698 A2 betrifft ein Halbleiterbauteil mit einem Übergitter.

In der Druckschrift WO 2005/036658 A1 ist ein Gruppe-III-N-Halbleiterbauteil beschrieben.

Eine Gruppe-III-Nitrid-Halbleitermehrschichtstruktur findet sich in der Druckschrift EP 2 019 437 A1.

Es ist ein Licht emittierendes Nitrid-Halbleiterbauteil in der Druckschrift EP 1 814 164 A2 angegeben.

Eine Beschreibung eines Halbleiterbauteils auf der Basis von AlInGaN ist der Druckschrift US 6 147 364 A zu entnehmen.

Es offenbart die Druckschrift DE 10 2008 032 318 A1 einen optoelektronischen Halbleiterchip gemäß dem Oberbegriff des Anspruchs 1.

In der Druckschrift US 6 121 638 A findet sich eine Halbleiterschichtenfolge mit AlGaN-Schichten.

Aus den Druckschriften US 2003/0 230 754 A1 und DE 10 2008 011 848 A1 sind LED-Chips mit Durchkontaktierungen durch eine aktive Zone hindurch bekannt.

Eine zu lösende Aufgabe besteht darin, einen optoelektronischen Halbleiterchip anzugeben, der gegenüber flüssigen Chemikalien eine hohe Undurchlässigkeit aufweist.

Die vorliegende Erfindung ist in Anspruch 1 definiert.

Erfindungsgemäß umfasst der optoelektronische Halbleiterchip eine auf AlGaN und/oder InAlGaN basierende, epitaktisch gewachsene Halbleiterschichtenfolge. Basierend bedeutet, dass die Halbleiterschichtenfolge überwiegend mindestens eines der genannten Materialien aufweist oder hieraus besteht. Dies schließt nicht aus, dass die Halbleiterschichtenfolge vergleichsweise kleine Mengen weiterer Stoffe, insbesondere Dotierstoffe, aufweisen kann.

Erfindungsgemäß umfasst die Halbleiterschichtenfolge eine p-dotierte Schichtenfolge, eine n-dotierte Schichtenfolge sowie eine aktive Zone, die sich zwischen der p-dotierten Schichtenfolge und der n-dotierten Schichtenfolge befindet. Der Begriff Schichtenfolge schließt hierbei nicht aus, dass die Schichtenfolge nur eine einzige, bezüglich ihrer physikalischen Eigenschaften homogene Schicht aufweist. Unter Schicht ist ein Bereich zu verstehen, der sich in einer Richtung senkrecht zu einer Wachstumsrichtung der Halbleiterschichtenfolge über die gesamte Halbleiterschichtenfolge oder über einen überwiegenden Teil der Halbleiterschichtenfolge, zum Beispiel über mehr als 80 %, erstreckt. Eine Schicht kann also ein ebenenartig ausgeformter, senkrecht zu einer Wachstumsrichtung orientierter Bereich der Halbleiterschichtenfolge mit einer bestimmten physikalischen Eigenschaft, wie einer bestimmten Materialzusammensetzung, sein. Verschiedene Schichten oder Bereiche können durch einen scharfen Übergang in eine Richtung parallel zur Wachstumsrichtung voneinander getrennt sein. Scharfer Übergang bedeutet insbesondere, dass ein Übergangsbereich zwischen den Schichten oder Bereichen hinsichtlich ihrer physikalischen Eigenschaft, wie einer Materialzusammensetzung, im Rahmen der Herstellungstoleranzen erfolgt und/oder höchstens fünf Monolagen, insbesondere höchstens zwei Monolagen einer Kristallstruktur beträgt.

Erfindungsgemäß ist die aktive Zone dazu eingerichtet, im Betrieb des Halbleiterchips eine elektromagnetische Strahlung im ultravioletten, im sichtbaren und/oder im nahinfraroten Spektralbereich zu erzeugen. Insbesondere liegt eine Hauptwellenlänge der von der aktiven Zone im Betrieb des Halbleiterchips erzeugten Strahlung bei Wellenlängen zwischen einschließlich 380 nm und 550 nm. Hauptwellenlänge ist diejenige Wellenlänge, bei der die in der aktiven Zone erzeugte Strahlung eine maximale Intensität pro nm spektraler Breite aufweist. Eine von dem Halbleiterchip emittierte, in der aktiven Zone erzeugte Strahlung ist ferner bevorzugt eine inkohärente Strahlung. Mit anderen Worten ist der Halbleiterchip dann als Leuchtdiode gestaltet und nicht als Laserdiode oder als Superlumineszenzdiode.

Erfindungsgemäß beinhaltet die Halbleiterschichtenfolge zwei Zwischenschichten, die auf AlₓGa₁-ₓN basieren. Mit anderen Worten handelt es sich bei den Zwischenschichten um auf GaN basierende Schichten, bei denen ein bestimmter Anteil von Ga-Gitterplätzen durch Al-Atome eingenommen ist. Die Zwischenschichten befinden sich auf derselben Seite der aktiven Zone wie die n-dotierte Schichtenfolge.

Gemäß zumindest einer Ausführungsform des optoelektronischen Halbleiterchips ist eine der Zwischenschichten undotiert. Undotiert bedeutet insbesondere, dass eine Dotierstoffkonzentration kleiner ist als 5 x 10¹⁶ pro cm³. Die Zwischenschicht kann dann an die n-dotierte Schichtenfolge unmittelbar angrenzen. Mit anderen Worten steht ein Material der Zwischenschicht dann in unmittelbarem Kontakt zu einem n-dotierten Material der n-dotierten Schichtenfolge. Bevorzugt befindet sich die Zwischenschicht innerhalb der Halbleiterschichtenfolge, sodass die Zwischenschicht keine Begrenzungsfläche der Halbleiterschichtenfolge in eine Richtung parallel zur Wachstumsrichtung bildet.

Erfindungsgemäß befinden sich die Zwischenschichten innerhalb der n-dotierten Schichtenfolge. Dass sich die Zwischenschichten innerhalb der n-dotierten Schichtenfolge befinden, bedeutet, dass die Zwischenschichten an beiden Seiten an weitere, n-dotierte Bereiche der n-dotierten Schichtenfolge grenzen. Durch die Zwischenschichten ist dann also keine Begrenzungsfläche der n-dotierten Schichtenfolge in eine Richtung parallel zur Wachstumsrichtung gebildet.

Erfindungsgemäß ist eine spezifische Chemikaliendurchlässigkeit der Zwischenschichten kleiner als für an die Zwischenschichten angrenzende Bereiche oder Schichten der Halbleiterschichtenfolge. Insbesondere weisen die Zwischenschichten eine spezifische Chemikaliendurchlässigkeit auf, die einer minimalen spezifischen Chemikaliendurchlässigkeit der gesamten Halbleiterschichtenfolge oder der gesamten n-dotierten Schichtenfolge entspricht. Spezifische Chemikaliendurchlässigkeit bedeutet Durchlässigkeit, bezogen auf eine bestimmte geometrische Dicke der Schicht und auf eine bestimmte Zeitspanne, gegenüber Flüssigkeiten mit einer besonders kleinen Viskosität. Kleine Viskosität kann bedeuten, dass die Flüssigkeit eine Viskosität von höchstens 2,5 mPas aufweist. Gemeint sind hierbei insbesondere solche Flüssigkeiten oder Chemikalien, die die Zwischenschichten nicht zersetzen. So sind die Zwischenschichten, verglichen mit der restlichen Halbleiterschichtenfolge, undurchlässig für Salpetersäure. Ebenso sind die Zwischenschichten bevorzugt undurchlässig für Dämpfe. Weiterhin hemmen die Zwischenschichten bevorzugt die Diffusion von Metallen wie Silber oder die Zwischenschichten werden von Metallen durch Diffusion nicht oder, im Vergleich zu den anderen Schichten der Halbleiterschichtenfolge, vermindert durchdrungen.

Erfindungsgemäß umfasst der optoelektronische Halbleiterchip eine auf AlGaN und/oder InAlGaN basierende, epitaktisch gewachsene Halbleiterschichtenfolge. Die Halbleiterschichtenfolge beinhaltet eine p-dotierte Schichtenfolge, eine n-dotierte Schichtenfolge und eine aktive Zone, die zur Erzeugung einer elektromagnetischen Strahlung vorgesehen ist und die sich zwischen der p-dotierten und der n-dotierten Schichtenfolge befindet. Weiterhin umfasst die Halbleiterschichtenfolge auf AlₓGa₁-ₓN basierende, undotierte oder n-dotierte Zwischenschichten. Die Zwischenschichten befinden sich innerhalb der Halbleiterschichtenfolge und weisen eine spezifische Chemikaliendurchlässigkeit gegenüber Salpetersäure auf, die geringer ist als eine spezifische Chemikaliendurchlässigkeit von an die Zwischenschichten angrenzenden Bereichen oder Schichten der Halbleiterschichtenfolge.

Durch die Verwendung solcher Zwischenschichten ist eine Durchlässigkeit der Halbleiterschichtenfolge gegenüber Salpetersäure effizient reduzierbar. Hierdurch sind eine höhere Ausbeute bei der Fertigung und eine höhere Zuverlässigkeit der Halbleiterchips realisierbar. Die Durchlässigkeit von Schichten der Halbeiterschichtenfolge gegenüber flüssigen Chemikalien oder gegenüber Dämpfen wird beispielsweise durch Versetzungen wie sogenannte Threading Dislocations hervorgerufen, die Kanäle oder Löcher in dem Halbleitermaterial bilden können. Die Risse sind beispielsweise Versetzungslinien. Das AlGaN der Zwischenschichten kann sich in und/oder an die Löcher und/oder Risse anlagern, wodurch die Risse und/oder Löcher und/oder Kerne der Versetzungslinien verkleinert werden können.

Gemäß zumindest einer Ausführungsform des Halbleiterchips weisen an die Zwischenschichten angrenzende Schichten der n-dotierten Schichtenfolge oder der Halbleiterschichtenfolge Risse und/oder Löcher auf, die sich quer zu einer Hauptausdehnungsrichtung der Zwischenschichten erstrecken. Entlang einer lateralen Richtung, also einer Richtung senkrecht zu einer Wachstumsrichtung der Halbleiterschichtenfolge, weisen die Risse und/oder die Löcher laterale Ausdehnungen auf der Nanometerskala oder der Mikrometerskala auf. Die Ausdehnung der Löcher und/oder Risse in einer lateralen Richtung beträgt beispielsweise höchstens 25 nm oder höchstens 50 nm oder höchstens 0,10 µm oder höchstens 0,25 µm oder höchstens 0,40 µm.

Gemäß zumindest einer Ausführungsform des optoelektronischen Halbleiterchips schließen die Zwischenschichten zumindest einen Teil der Risse und/oder der Löcher ab. Mit anderen Worten überdecken die Zwischenschichten zumindest einen Teil der Löcher und/oder der Risse vollständig. Insbesondere weisen die Zwischenschichten Erhebungen auf, die sich von der aktiven Zone weg und/oder zu der aktiven Zone hin in die Risse und/oder in die Löcher hinein erstrecken. Die Erhebungen, die bevorzugt mit demselben Material wie die Zwischenschichten geformt sind, stehen stellenweise in unmittelbarem, direktem, physischem Kontakt zu einem Material der Schicht, in die sich die Risse und/oder die Löcher hinein erstrecken.

Gemäß zumindest einer Ausführungsform des optoelektronischen Halbleiterchips ist durch die Zwischenschichten ein Durchmesser und/oder eine Spannweite der Löcher und/oder Risse verringert. Das heißt, mindestens ein Teil der Risse und/oder Löcher, beispielsweise mehr als 80 % oder mehr als 95 % oder mehr als 99 % der Löcher und/oder Risse sind, entlang der Wachstumsrichtung gesehen, nach der Zwischenschicht kleiner als vor den Zwischenschichten. Dies schließt mit ein, dass die Löcher und/oder Risse von den Zwischenschichten vollständig überdeckt und/oder verstopft und/oder unterbrochen sind.

Gemäß zumindest einer Ausführungsform des optoelektronischen Halbleiterchips erstrecken sich die Löcher und/oder Risse, entlang der Wachstumsrichtung gesehen, nach den Zwischenschichten mindestens zum Teil weiter. Mit anderen Worten ist es möglich, dass die Zwischenschichten die Löcher und/oder Risse gegenüber einem Durchdringen von flüssigen Chemikalien abdichten, jedoch die Löcher und/oder Risse als Störstellen im Kristallgitter nicht beseitigt, sodass die Risse und/oder Löcher mindestens teilweise beiderseits der Zwischenschichten vorliegen. Beispielsweise beträgt die Anzahl der Löcher, in Wachstumsrichtung gesehen, unmittelbar nach den Zwischenschichten mindestens 50 % oder mindestens 75 % oder mindestens 90 % und/oder höchstens 90 % oder höchstens 95 % der Anzahl der Löcher unmittelbar vor den Zwischenschichten. Hinsichtlich der Risse oder Versetzungslinien ist es möglich, dass diese durch die Zwischenschichten vollständig beseitigt oder in ihrer Anzahl um mindestens 50 % oder um mindestens 75 % oder um mindestens 90 % reduziert werden.

Halbleiterschichtenfolgen für optoelektronische Halbleiterchips, insbesondere für Leuchtdioden, werden beispielsweise auf Saphir-Substraten epitaktisch gewachsen. Beim Aufwachsen können insbesondere Löcher in dem zu wachsenden Halbleitermaterial entstehen. Ebenso können insbesondere Risse in einem Laserabhebeverfahren, bei dem die fertig gewachsene Halbleiterschichtenfolge von dem Substrat entfernt wird, entstehen. Die Löcher und/oder Rissen an einer ehemals dem Substrat zugewandten Begrenzungsfläche der Halbleiterschichtenfolge können, beispielsweise bei dem Laserabhebeverfahren selbst oder bei einem Erzeugen einer Aufrauung etwa mittels Nassätzen, freigelegt werden, sodass zumindest ein Teil der Löcher und/oder Risse also zu dieser Begrenzungsfläche der Halbleiterschichtenfolge reicht.

Über diese freiliegenden Löcher und/oder Risse kann eine flüssige Chemikalie die Halbleiterschichtenfolge in einen nachfolgenden Prozessschritt durchdringen und insbesondere einen Spiegel, beispielsweise einen Silberspiegel, der an einer dem Aufwachssubstrat abgewandten Seite der Halbleiterschichtenfolge oder an einer Durchkontaktierung zuvor aufgebracht wurde, angreifen. Durch eine derartige Beschädigung des Spiegels verringert sich eine Lichtauskoppeleffizienz. Durch die Risse und/oder Löcher, die auch Defekte in der Halbleiterschichtenfolge darstellen, kann weiterhin eine Minderung einer Effizienz beim Erzeugen der Strahlung in der aktiven Zone auftreten. Ebenso können durch die Risse und/oder Löcher Kleinstromprobleme in der Strom-Spannung-Charakteristik des Halbleiterchips auftreten.

Da bei einem epitaktischen Aufwachsen, beispielsweise bei einem so genannten MOVPE-Prozess, Al-Atome an einer Kristalloberfläche eine kleinere Mobilität aufzeigen als Ga-Atome, können AlGaN-Schichten im Vergleich zu reinen GaN-Schichten beim Aufwachsen eine glättende Wirkung auf eine Oberflächenmorphologie haben. Es reagieren AlGaN-Schichten also deutlich unempfindlicher auf ein Facettenwachstum als GaN-Schichten, wodurch eventuell vorhandene Löcher, Risse und/oder Kanäle in einem GaN-Kristall durch eine solche AlGaN-Schicht geschlossen oder verkleinert werden können.

Gemäß zumindest einer Ausführungsform ist eine der Zwischenschichten mit einer Dotierstoffkonzentration zwischen einschließlich 2 x 10¹⁸ pro cm³ und 5 x 10¹⁹ pro cm³, bevorzugt mit einer Dotierstoffkonzentration zwischen einschließlich 4 x 10¹⁸ pro cm³ und 3 x 10¹⁹ pro cm³, insbesondere zwischen einschließlich 6 x 10¹⁸ pro cm³ und 2 x 10¹⁹ pro cm³ dotiert. Eine Dotierung erfolgt zum Beispiel mit Si-Atomen.

Erfindungsgemäß weist der Anteil x der Ga-Gitterplätze, der durch Al-Atome eingenommen ist, einen Wert zwischen einschließlich 0,03 und 0,5, bevorzugt zwischen einschließlich 0,07 und 0,13, beispielsweise um 0,1, auf.

Erfindungsgemäß weisen die Zwischenschichten eine Dicke zwischen einschließlich 15 nm und 250 nm oder zwischen einschließlich 15 nm und 200 nm, insbesondere zwischen einschließlich 25 nm und 100 nm, auf.

Erfindungsgemäß ist eine der Zwischenschichten eine ununterbrochene, durchgängige Schicht. Mit anderen Worten sind in eine Richtung senkrecht zur Wachstumsrichtung dann keine Öffnungen oder Durchbrüche in dieser Zwischenschicht gezielt hergestellt. Diese Zwischenschicht erstreckt sich also in einer Richtung senkrecht zur Wachstumsrichtung über die gesamte Halbleiterschichtenfolge, ohne dass gezielt erzeugte Unterbrechungen vorhanden sind. Dass diese Zwischenschicht eine ununterbrochene, durchgängige Schicht ist, schließt nicht aus, dass Defekte in dem Kristallgitter der Halbleiterschichtenfolge wie Risse und/oder Löcher kleine, unbeabsichtigte Öffnungen in dieser Zwischenschicht bilden. Mit anderen Worten ist es möglich, dass nicht alle der Risse und/oder Löcher durch diese Zwischenschicht geschlossen sind. Bevorzugt jedoch treten keine solchen unbeabsichtigten Öffnungen auf.

Erfindungsgemäß durchdringt wenigstens eine elektrische Durchkontaktierung die aktive Zone und eine der Zwischenschichten, die in der Halbleiterschichtenfolge gebildet sind. In diesem Fall ist es möglich, dass sich alle elektrische Kontaktierungen zur Bestromung des Halbleiterchips an nur einer Seite der aktiven Zone befinden. Mit anderen Worten kann der Halbleiterchip dann als so genannter Flip-Chip geformt sein.

Besonders in dieser Ausführungsform ist ein Abstand von einer äußeren Begrenzungsfläche der Halbleiterschichtenfolge bis hin zu einem Spiegel, etwa an der Durchkontaktierung, vergleichsweise klein und beträgt zum Beispiel zirka 2 µm. Bei derart geringen Abständen ist die Wahrscheinlichkeit, dass Risse und/oder Löcher in der Halbleiterschichtenfolge von einer äußeren Begrenzungsfläche bis zu dem Spiegel reichen, besonders groß, insbesondere auch dann, wenn die Halbleiterschichtenfolge über ein Laserabhebeverfahren von einem Substrat getrennt und wenn an der äußeren Begrenzungsfläche eine Aufrauung in der Halbleiterschichtenfolge erzeugt ist. Das heißt, speziell bei vergleichsweise dünnen Halbleiterschichtenfolgen mit Durchkontaktierungen ist eine Steigerung der Ausbeute bei der Herstellung durch die Verwendung wenigstens einer Zwischenschicht besonders groß.

Erfindungsgemäß grenzen die auf AlGaN basierenden Zwischenschichten beidseitig an GaN-Schichten, die keinen Al-Gehalt aufweisen. Bevorzugt ist mindestens eine dieser GaN-Schichten höher dotiert als die betreffende Zwischenschicht und zum Beispiel als Stromaufweitungsschicht ausgebildet. Die andere dieser GaN-Schichten kann eine um mindestens einen Faktor 2 geringere Dotierstoffkonzentration als die betreffende Zwischenschicht aufweisen.

Gemäß zumindest einer Ausführungsform des optoelektronischen Halbleiterchips umfasst dieser genau zwei der Zwischenschichten. Es sind dann bevorzugt keine weiteren Schichten in der Halbleiterschichtenfolge vorhanden, die eine den Zwischenschichten entsprechende Materialzusammensetzung aufweisen. Insbesondere sind die Zwischenschichten kein Bestandteil eines sogenannten Übergitters.

Nachfolgend wird ein hier beschriebener optoelektronischer Halbleiterchip unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 bis 5, 8, 9A, 9B und 11: schematische Schnittdarstellungen von nicht erfindungsgemäßen, die Erfindung weiter illustrierenden Abwandlungen von optoelektronischen Halbleiterchips,
- Figuren 6 und 9C: schematische Schnittdarstellungen von Ausführungsbeispielen von hier beschriebenen optoelektronischen Halbleiterchips, und
- Figuren 7 und 10: schematische Schnittdarstellungen von Leuchtdiodenchips.

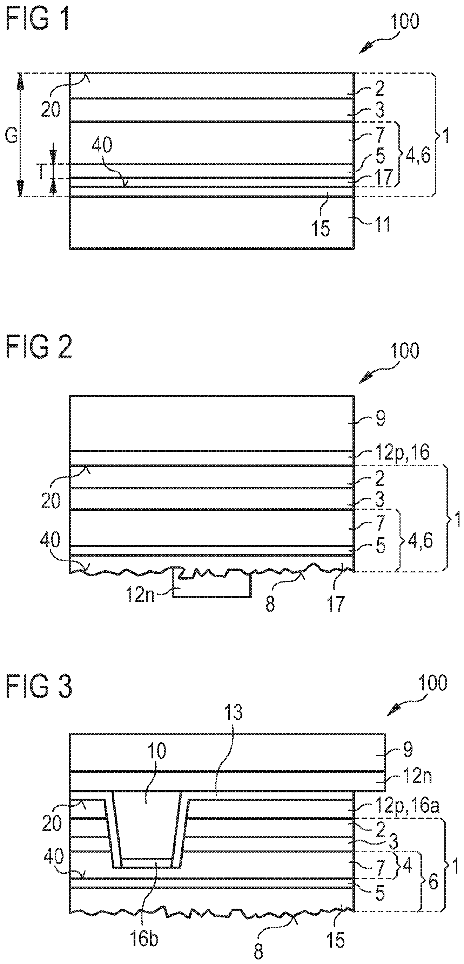

In Figur 1 ist eine Abwandlung eines optoelektronischen Halbleiterchips 100 dargestellt. Bei dem Halbleiterchip 100 handelt es sich insbesondere um eine Leuchtdiode, die im Betrieb eine inkohärente Strahlung emittiert.

Auf einem Aufwachssubstrat 11 ist eine Halbleiterschichtenfolge 1 epitaktisch aufgewachsen. Die Halbleiterschichtenfolge 1 basiert auf AlGaN und/oder InAlGaN. Eine Gesamtdicke G der Halbleiterschichtenfolge 1 liegt beispielsweise zwischen einschließlich 1,0 µm und 10 µm, insbesondere zwischen einschließlich 1,5 µm und 7,0 µm, insbesondere zirka 5 µm bis 6 µm.

Unmittelbar an dem Aufwachssubstrat 11 befindet sich eine undotierte GaN-Schicht 15. Die undotierte Schicht 15 weist zum Beispiel eine Dicke zwischen einschließlich 300 nm und 400 nm auf. An einer dem Aufwachssubstrat 11 abgewandten Seite der undotierten Schicht 15 ist eine n-dotierte Teilschicht 17 erzeugt, die Teil einer n-dotierten Schichtenfolge 4 der Halbleiterschichtenfolge 1 ist. Es ist möglich, dass nur eine der Schichten 15, 17 vorhanden ist.

An einer der n-dotierten Schichtenfolge 4 abgewandten Seite des Aufwachssubstrates 11 befindet sich eine aktive Zone 3, gefolgt von einer p-dotierten Schichtenfolge 2. Die sich zwischen der n-dotierten Schichtenfolge 4 und der p-dotierten Schichtenfolge 2 befindliche aktive Zone 2 weist insbesondere mindestens eine Quantentopfstruktur beliebiger Dimensionalität auf, bevorzugt mehrere Quantentopfstrukturen. Beispielsweise wird im Betrieb in der aktiven Zone ultraviolette Strahlung, blaues oder grünes Licht erzeugt.

Die n-dotierte Schichtenfolge 4 beinhaltet eine Zwischenschicht 5. Die Zwischenschicht 5 befindet sich innerhalb der n-dotierten Schichtenfolge 4 zwischen der Teilschicht 17 und einer n-dotierten Stromaufweitungsschicht 7, die ebenfalls Teil der n-dotierten Schichtenfolge 4 ist. Mit anderen Worten weist die Zwischenschicht 5 keinen unmittelbaren Kontakt zu dem Aufwachssubstrat 11 oder zu der aktiven Zone 3 auf. Eine minimale Dicke der undotierten Schicht 15 und/oder der Teilschicht 17 ist also mindestens so einzustellen, dass das Aufwachssubstrat 11 im Wesentlichen vollständig von mindestens einer dieser Schichten 15, 17 bedeckt ist und eine dem Aufwachssubstrat 11 abgewandte Seite dieser Schichten 15, 17 im Wesentlichen eben geformt ist.

Eine Dicke T der Zwischenschicht 5 liegt zwischen einschließlich 25 nm und 150 nm. Die Zwischenschicht 5 basiert auf AlGaN, wobei ein Anteil von einschließlich 3 % bis 20 %, insbesondere zirka 10 %, der Gallium-Gitterplätze, im Vergleich zu reinem GaN, mit Aluminiumatomen besetzt ist. Eine Dotierstoffkonzentration der Zwischenschicht in dieser Abwandlung liegt bevorzugt zwischen einschließlich 4 x 10¹⁸ pro cm³ und 5 x 10¹⁹ pro cm³, speziell zwischen einschließlich 6 x 10¹⁸ pro cm³ und 2 x 10¹⁹ pro cm³. Ein Dotierstoff ist beispielsweise Silizium. Die Zwischenschicht 5 ist eine geschlossene, durchgehende Schicht. Mit anderen Worten sind in der Zwischenschicht 5 keine Öffnungen oder Durchbrüche gezielt erzeugt.

Eine Pufferschicht 6 der Halbleiterschichtenfolge 1 ist durch die Teilschicht 17, die Zwischenschicht 5 und die Stromaufweitungsschicht 7 gebildet und umfasst somit die n-dotierte Schichtenfolge 4. Eine Dicke der Pufferschicht 6 beträgt zum Beispiel zwischen einschließlich 300 nm und 6 µm, bevorzugt zwischen einschließlich 500 nm und 1,8 µm. Eine Dicke der Pufferschicht 6 übersteigt eine Dicke der p-dotierten Schichtenfolge 2, die im Ausführungsbeispiel gemäß Figur 1 nur durch eine einzige Schicht gebildet ist, bevorzugt um mindestens einen Faktor 10 oder um mindestens einen Faktor 20.

Die Abwandlung des Halbleiterchips 100 gemäß Figur 2 ist zum Beispiel eine Weiterbildung des Halbleiterchips 100 gemäß Figur 1. Auf einer der aktiven Zone 3 abgewandten Seite 20 der p-dotierten Schichtenfolge 2 ist eine p-Kontaktschicht 12p aufgebracht. Die p-Kontaktschicht 12p ist insbesondere durch eine oder mehrere metallische Schichten gebildet und kann einen Spiegel 16 für eine in der aktiven Zone 3 erzeugte Strahlung darstellen und/oder umfassen. An einer der aktiven Zone 3 abgewandten Seite der p-Kontaktschicht 12p ist ein Träger 9 angebracht, der den Halbleiterchip 100 mechanisch trägt. Eine Dicke des Trägers 9 liegt bevorzugt zwischen einschließlich 40 µm und 600 µm. Durch den Träger 9 ist es möglich, den Halbleiterchip 100 beispielsweise mittels eines so genannten Pick-and-Place-Prozesses zu handhaben.

An einer der aktiven Zone 3 abgewandten Seite 40 der Teilschicht 17 der n-dotierten Schichtenfolge 4 ist eine Aufrauung 8 erzeugt, beispielsweise mittels eines Ätzens. Die Aufrauung 8 reicht nicht bis zu der Zwischenschicht 5. Durch das Erzeugen der Aufrauung 8 kann die undotierte Schicht 15 gemäß Figur 1 vollständig entfernt sein. Über die Aufrauung 8 ist eine Auskoppeleffizienz der Strahlung aus dem Halbleiterchip 100 steigerbar. Eine mittlere Rauheit der Aufrauung 8 liegt bevorzugt zwischen einschließlich 0,4 µm und 4,0 µm, insbesondere zwischen einschließlich 0,5 µm und 1,5 µm. Ferner ist an der Seite 40, in der die Aufrauung 8 geformt ist, eine n-Kontaktierung 12n aufgebracht. Die n-Kontaktierung 12n ist insbesondere durch eine oder mehrere metallische Schichten und/oder durch ein transparentes leitfähiges Oxid gebildet. Insbesondere ist die n-Kontaktierung 12n ein so genanntes Bond-Pad. Ein Stromfluss erfolgt also gemäß Figur 2 auch durch die Zwischenschicht 5 hindurch, sodass es erforderlich ist, die Zwischenschicht 5 elektrisch leitend, also insbesondere n-dotiert, auszubilden.

Der Halbleiterchip 100 gemäß Figur 2 kann aus dem Halbleiterchip 100 gemäß Figur 1 wie folgt erzeugt sein: Nach dem Aufwachsen der Halbleiterschichtenfolge 100 auf dem Aufwachssubstrat 11 werden die p-Kontaktierung 12p und anschließend auf die p-Kontaktierung 12p der Träger 9 angebracht. Anschließend wird das Aufwachssubstrat 11, insbesondere mittels eines Laserabhebeverfahrens, englisch Laser-Lift-Off, von der Halbleiterschichtenfolge 1 und dem Träger 9 entfernt. Hierbei wird ein dünner Bereich der n-dotierten Schichtenfolge 4, der sich nahe dem Aufwachssubstrat 11 befindet, zersetzt, insbesondere ein Teil der undotierten Schicht 15. Nach dem Entfernen des Aufwachssubstrates 11 von der Halbleiterschichtenfolge 1 wird insbesondere über ein Ätzen die Aufrauung 8 in der Teilschicht 17 der n-dotierten Schichtenfolge 4 an der Seite 40 gebildet.

Bei der Abwandlung des Halbleiterchips 100 gemäß Figur 3 befinden sich die n-Kontaktierung 12n und die p-Kontaktierung 12p an derselben Seite der aktiven Zone 3. Dies ist speziell dadurch ermöglicht, dass, ausgehend von der n-Kontaktierung 12n, eine Durchkontaktierung 10 durch die p-dotierte Schichtenfolge 2 und durch die aktive Zone 3 hin zur n-Schichtenfolge 4 geformt ist. Die Durchkontaktierung 10 kann durch ein oder durch mehrere Metalle gebildet. Über die Durchkontaktierung 10 ist eine direkte elektrische Verbindung zwischen der n-Kontaktierung 12n, die zwischen dem Träger 9 und der p-Kontaktierung 12p geformt ist, und der Stromaufweitungsschicht 7 der n-dotierten Schichtenfolge 4 hergestellt.

Die n-Kontaktierung 12n sowie die Durchkontaktierung 10 sind von der aktiven Zone 3, der p-dotierten Schichtenfolge 2 sowie der p-Kontaktierung 12p durch eine elektrisch isolierende Schicht 13, die zum Beispiel mit einem transparenten Material wie Siliziumdioxid oder Siliziumnitrid geformt ist, getrennt. Die p-Kontaktierung 12p dient auch in dieser Abwandlung als Spiegel 16a für die in der aktiven Zone 3 im Betrieb erzeugte Strahlung, die über die Aufrauung 8 aus dem Halbleiterchip 100 ausgekoppelt wird.

Bevorzugt ist an einer der Aufrauung 8 zugewandten Seite der Durchkontaktierung 10 ein weiterer Spiegel 16b, beispielsweise ein Silberspiegel, angebracht. Anders als gezeichnet ist es möglich, dass sich der Spiegel 16b auch teilsweise oder vollständig zwischen die isolierende Schicht 13 und die Durchkontaktierung 10 erstreckt.

Eine Bestromung der aktiven Zone 3 erfolgt also gemäß dieser Abwandlung nicht über die Zwischenschicht 5. Somit kann die Zwischenschicht 5 daher auch undotiert sein und einen höheren Al-Gehalt zwischen einschließlich 5 % und 50 % aufweisen oder auch auf AlN basieren oder aus AlN bestehen.

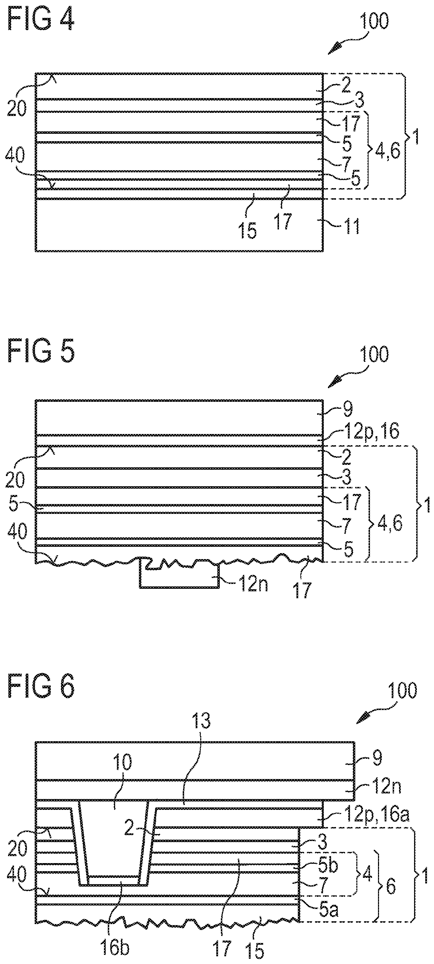

Bei der Abwandlung gemäß Figur 4 weist die Halbleiterschichtenfolge 1 des Halbleiterchips 100 zwei Zwischenschichten 5 auf. Zwischen den beiden Zwischenschichten 5 befindet sich die hoch n-dotierte Stromaufweitungsschicht 7. Die Stromaufweitungsschicht 7 basiert zum Beispiel auf GaN und nicht auf AlGaN wie die Zwischenschichten 5 und weist eine hohe Dotierstoffkonzentration von bevorzugt mindestens 5 x 10¹⁸ pro cm³ auf. Die Stromaufweitungsschicht 7 grenzt bevorzugt unmittelbar an die beiden Zwischenschichten 5. Der weitere Aufbau des Halbleiterchips 100 gemäß Figur 4 folgt im Wesentlichen dem Ausführungsbeispiel gemäß Figur 1.

Der Halbleiterchip 100 gemäß Figur 5 ist eine Weiterbildung des Halbleiterchips 100 gemäß Figur 4, in analoger Weise zu den Figuren 1 und 2. Da ein Stromfluss von der n-Kontaktierung 12n zur p-Kontaktierung 12p über die zwei Zwischenschichten 5 erfolgt, sind die Zwischenschichten 5 dotiert und elektrisch leitend ausgebildet.

Beim Ausführungsbeispiel des Halbleiterchips 100 gemäß Figur 6 ist die Zwischenschicht 5b von der Durchkontaktierung 10 durchdrungen, wohingegen die Zwischenschicht 5a eine ununterbrochene, durchgehende Schicht ist, wie die Zwischenschichten 5 gemäß den Figuren 1 bis 5. Die Durchkontaktierung 10 verbindet die n-Kontaktierung 12n elektrisch unmittelbar mit der Stromaufweitungsschicht 7. Die von der Durchkontaktierung 10 durchdrungene Zwischenschicht 5b kann in diesem Ausführungsbeispiel zu einer Endpunktdetektion zur Ätzung der Ausnehmung für die Durchkontaktierung 10 dienen. Da ein Stromfluss nicht über die Zwischenschicht 5a erfolgt, kann die Zwischenschicht 5a entweder dotiert oder auch undotiert sein.

Wie auch in allen anderen Abwandlungen ist es möglich, dass die Zwischenschichten 5, 5a, 5b sowie die Stromaufweitungsschicht 7, die undotierte Schicht 15 und/oder die Teilschicht 17 einen Teil der Pufferschicht 6 bilden.

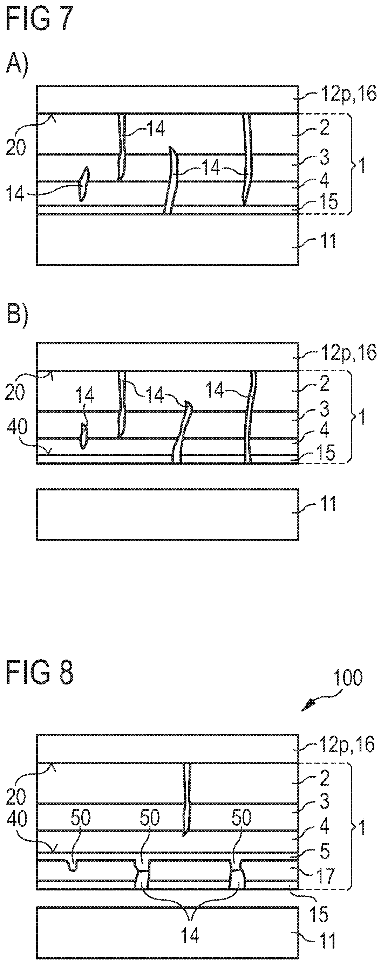

In den Figuren 7A und 7B ist ein Leuchtdiodenchip ohne Zwischenschichten gezeigt. Beim Aufwachsen der Halbleiterschichtenfolge 1 auf dem Aufwachssubstrat 11 bilden sich entweder an der Grenzfläche zwischen der undotierten Schicht 15 oder der n-dotierten Schichtenfolge 4, die gemäß Figur 7 durch eine einzige Schicht gebildet ist, und dem Aufwachssubstrat 11 oder auch während des Aufwachsens oder beim Laserabhebeverfahren innerhalb der Halbleiterschichtenfolge 1 Risse und/oder Löcher 14, vergleiche Figur 7A. Bei einem Abtrennen des Aufwachssubstrats 11 von der Halbleiterschichtenfolge 1, beispielsweise durch das Laserabhebeverfahren, wird ein Teil der Risse und/oder Löcher 14 freigelegt, siehe Figur 7B.

Ein Anteil der Risse und/oder Löcher 14 reicht von der Seite 40 der n-dotierten Schichtenfolge 4 bis hin zu der p-Kontaktierung 12p. Über diese Löcher und/oder Risse 14 ist es möglich, dass in einem späteren Verfahrensschritt, beispielsweise zur Erzeugung einer Aufrauung an der n-dotierten Schichtenfolge 4, eine flüssige Chemikalie wie Salpetersäure oder Kalilauge durch die Halbleiterschichtenfolge 1 bis hin zu der p-Kontaktierung 12p gelangt, die Halbleiterschichtenfolge 1 also vollständig penetriert.

Etwa durch diese Chemikalien ist es möglich, dass die bevorzugt als Spiegel 16, 16a ausgeführte p-Kontaktierung 12p angegriffen oder beschädigt wird, wodurch eine Reflektivität der p-Kontaktierung 12p vermindert und somit eine Auskoppeleffizienz von Strahlung aus dem Halbleiterchip reduziert werden kann. Eine Gefahr einer Beschädigung des Spiegels 16b an der Durchkontaktierung 10, siehe Figuren 3 und 6, ist aufgrund des geringen Abstandes zwischen dem Spiegel 16b und der Aufrauung 8 sogar noch höher.

In Figur 8 ist eine Abwandlung des Halbleiterchips 100 mit der Zwischenschicht 5 illustriert, nach dem das Aufwachssubstrat 11 von der Halbleiterschichtenfolge 1 abgetrennt ist. Anders als gezeichnet ist es ebenso möglich, dass nur eine der Schichten 15, 17 vorliegt. Auch die Halbleiterschichtenfolge 1 gemäß Figur 8 weist Risse und/oder Löcher 14 auf, die von der Seite 40 der n-dotierten Schichtenfolge 4 hin zu der p-Kontaktierung 12p verlaufen und die durch beispielsweise ein Laserabhebeverfahren an der dem abgetrennten Aufwachssubstrat 11 zugewandten Seite 40 freigelegt sind.

Jedoch sind gemäß Figur 8 alle oder wenigstens ein Teil der Risse 14 und/oder Löcher 14, die von der Seite 40 hin zu der aktiven Zone 3 verlaufen, durch die Zwischenschicht 5 abgedeckt und verschlossen. Bei einem Aufwachsen der Halbleiterschichtenfolge 1 beziehungsweise der Zwischenschicht 5 entstehen hierbei Erhebungen 50 der Zwischenschicht 5, die sich weg von der aktiven Zone 3 hin zu dem Aufwachssubstrat 11 erstrecken. Die Erhebungen 50 sind mit demselben Material gebildet wie die Zwischenschicht 5. Die Erhebungen 50 erstrecken sich somit pfropfenartig in wenigstens einen Teil der Risse und/oder Löcher 14 und stehen in unmittelbarer Verbindung wenigstens mit einem Teil von lateralen Begrenzungsflächen der Risse und/oder Löcher 14, in einer Richtung senkrecht zu einer Wachstumsrichtung der Halbleiterschichtenfolge 1. Ebenso ist es möglich, dass zumindest ein Teil der Risse und/oder Löcher 14 vollständig durch ein Material der Erhebungen 50 ausgefüllt ist.

Die Zwischenschicht 5 wird also als eine Art Abdichtung oder Verschlussschicht für die Risse und/oder Löcher 14 verwendet. Dies ist insbesondere dadurch ermöglicht, dass die Zwischenschicht 5 und die Erhebungen 50 mit AlGaN anstelle von GaN geformt sind. Aluminiumatome weisen beim epitaktischen Aufwachsen an einer Oberfläche eine geringere Mobilität auf als Galliumatome. Hierdurch ist das Schließen und teilweise Füllen der Risse und/oder Löcher 14 ermöglicht.

Zwar können beim weiteren epitaktischen Aufwachsen der Halbleiterschichtenfolge 1 weitere Risse und/oder Löcher 14 entstehen, die beispielsweise von einer dem Aufwachssubstrat 11 abgewandten Seite 40 der n-dotierten Schichtenfolge bis zur p-Kontaktierung 12p reichen, jedoch besteht keine durchgehende Verbindung durch die Risse und/oder Löcher 14 von einer der aktiven Zone 3 abgewandten Seite der Schichten 15, 17 hin zu der p-Kontaktierung 12p oder hin zu dem Spiegel 16b an der Durchkontaktierung 10 gemäß den Figuren 3 und 6. Somit erfolgt auch keine Beschädigung der Spiegel 16, 16a, 16b oder eines anderen Materials der Durchkontaktierung 10 oder der Kontaktierungen 12n, 12p, wie zum Beispiel Al, WN und/oder Ti, bei nachgeschalteten Prozessschritten, insbesondere bei solchen Prozessschritten, bei denen Chemikalien mit einer geringeren Viskosität eingesetzt werden. Der Effekt der Abdichtung von Rissen und/oder Löchern 14 durch die Zwischenschicht 5 ist speziell dann von Bedeutung, wenn ein Abstand zwischen der Aufrauung 8 oder einer äußeren Begrenzungsfläche der Halbleiterschichtenfolge 1 und dem Spiegel 16, 16a, 16b besonders klein ist, wie speziell bei den Abwandlungen beziehungsweise Ausführungsbeispielen gemäß der Figuren 3 und 6.

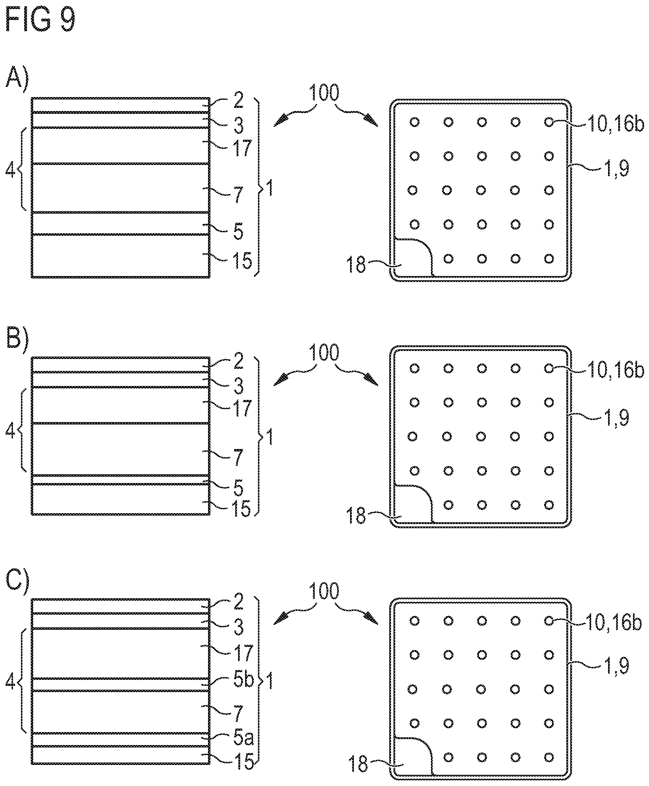

In Figur 9 sind weitere Abwandlungen beziehungsweise Ausführungsbeispiele der Halbleiterchips 100 in einer Schnittdarstellung und in einer zugehörigen Draufsicht auf eine Strahlungsdurchtrittsseite mit einem Kontaktbereich 18, zum Beispiel für einen Bond-Draht, gezeigt. Die Halbleiterchips 100 weisen jeweils mehrere der in den Schnittdarstellungen nicht gezeichneten Durchkontaktierungen 10 und Spiegel 16b auf, vergleiche die Figuren 3 und 6. Die Durchkontaktierungen 10 und Spiegel 16b reichen also jeweils von der p-leitenden Schichtenfolge 2 her bis in die Stromaufweitungsschicht 7, die je ein Dicke von zirka 1,1 µm aufweist.

Gemäß der Abwandlung der Figur 9A weist die Zwischenschicht 5 eine Dicke von zirka 60 nm auf, gemäß der Abwandlung der Figur 9B eine Dicke von zirka 30 nm. Die n-dotierte Schicht 17 hat jeweils eine Dicke von zirka 1,3 µm. Gemäß dem Ausführungsbeispiel der Figur 9C befindet sich die Stromaufweitungsschicht 7 zwischen den zwei Zwischenschichten 5a, 5b mit je einer Dicke von zirka 30 nm. Es ist also jeweils mindestens eine Zwischenschicht 5, 5a, 5b an einer der aktiven Zone 3 abgewandten Seite der Stromaufweitungsschicht 7 vorhanden. In den zugehörigen Draufsichten auf die Strahlungsdurchtrittsseite ist zu sehen, dass die Spiegel 16b keine verminderte Reflektivität aufzeigen und somit nicht beschädigt sind. Insbesondere verlässt durch die Strahlungsdurchtrittsseite mehr als 50 % oder mehr als 80 % der Strahlung den Halbleiterchip 100.

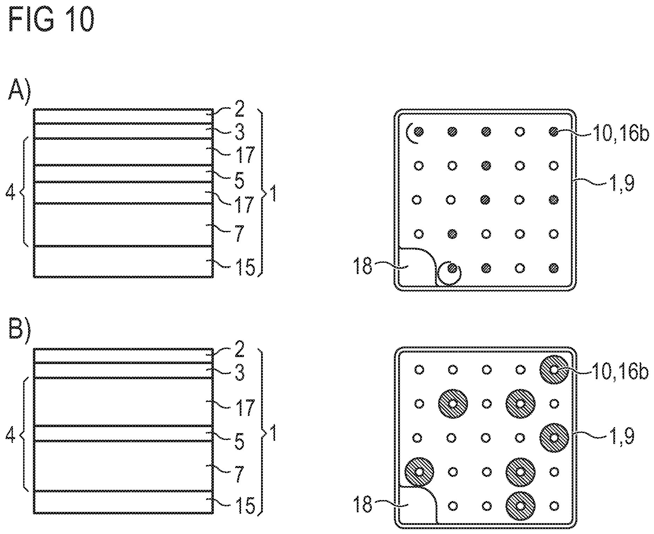

Bei den Leuchtdiodenchips gemäß Figur 10A und 10B befinden sich die Zwischenschichten 5 jeweils zwischen der Stromaufweitungsschicht 7 und der aktiven Zone 3. Es ist also zwischen den Spiegeln 16b und der Strahlungsdurchtrittsseite keine Zwischenschicht vorhanden. Hierdurch werden die Spiegel 16b etwa beim Erzeugen einer Aufrauung an der Strahlungsdurchtrittsseite flüssigen Chemikalien ausgesetzt und dadurch beschädigt, zu sehen in einer Dunkelfärbung und somit verminderten Reflektivität der Spiegel 16b.

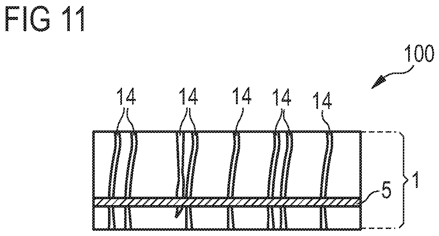

Bei der Abwandlung des Halbleiterchips 100 der Figur 11 ist die Halbleiterschichtenfolge 1 mit der Zwischenschicht 5 nur vereinfacht in einer Schnittdarstellung gezeigt, insbesondere elektrische Kontakte sind nicht gezeichnet. Durch die Zwischenschicht 5 sind die Löcher und/oder Risse 14 in der Halbleiterschichtenfolge 1 in einem Durchmesser verringert oder, im Bereich der Zwischenschicht 5, vollständig von dem Material der Zwischenschicht 5 überdeckt oder verstopft. Entlang der Wachstumsrichtung der Halbleiterschichtenfolge gesehen, sind die Löcher und/oder Risse 14 vor der Zwischenschicht 5 also größer als nach der Zwischenschicht 5. Außerdem kann eine Richtung, entlang der die Risse und/oder Löcher 14 verlaufen, durch die Zwischenschicht 5 geändert sein. Hierdurch sind die Löcher und/oder Risse 14 gegenüber flüssigen Chemikalien und/oder gegenüber Dämpfen und/oder der Diffusion von Metallen abgedichtet.

Durch die Zwischenschicht 5 sind die Löcher und/oder Risse 14 jedoch nicht im Kristallgitter der Halbleiterschichtenfolge 1 eliminiert, sondern setzten sich, entlang der Wachstumsrichtung der Halbleiterschichtenfolge 1 gesehen, nach der Zwischenschicht 5 fort. Mit anderen Worten ist es möglich, dass eine Anzahl der Risse und/oder Löcher 14 durch die Zwischenschicht 5 nicht oder nicht signifikant verringert wird. Ungeachtet der ungefähr gleichbleibenden Anzahl der Risse und/oder Löcher 14 beiderseits der Zwischenschicht 14 sind die Löcher und/oder Risse 14 durch das Material der Zwischenschicht 5 jedoch chemikalienundurchlässig.

## Patentansprüche

1. Optoelektronischer Halbleiterchip (100) mit einer auf AlGaN oder InAlGaN basierenden, epitaktisch gewachsenen Halbleiterschichtenfolge (1), die aufweist:
- eine p-dotierte Schichtenfolge (2),
- eine n-dotierte Schichtenfolge (4),
- eine aktive Zone (3), die zur Erzeugung einer elektromagnetischen Strahlung vorgesehen ist und die sich zwischen der p-dotierten Schichtenfolge (2) und der n-dotierten Schichtenfolge (4) befindet, und
- zwei auf AlₓGa₁-ₓN basierende Zwischenschichten (5a, 5b), die sich an derselben Seite der aktiven Zone (3) wie die n-dotierte Schichtenfolge (4) befinden und die beidseitig je an GaN-Schichten, die keinen Al-Anteil aufweisen, angrenzen, wobei
- eine erste der Zwischenschichten (5a) eine ununterbrochene, durchgängige Schicht ist,
- eine zweite der Zwischenschichten (5b) zwischen der ersten Zwischenschicht (5a) und der aktiven Zone (3) angeordnet ist und wenigstens eine elektrische Durchkontaktierung (10) die aktive Zone (3) und die zweite Zwischenschicht (5b) durchdringt, sodass sich alle elektrischen Kontaktierungen zur Bestromung des Halbleiterchips (100) an nur einer Seite der aktiven Zone (3) befinden, und über die erste der Zwischenschichten (5a) kein Stromfluss erfolgt, sodass eine Bestromung der aktiven Zone (3) nicht über die erste der Zwischenschichten (5a) erfolgt, wohingegen ein Stromfluss durch die zweite der Zwischenschichten (5b) hindurch erfolgt,
**dadurch gekennzeichnet, dass**
- die Halbleiterschichtenfolge (1) genau zwei der auf AlₓGa₁₋ₓ N basierenden Zwischenschichten (5a, 5b) aufweist,
- die auf AlₓGa₁₋ₓ N basierenden Zwischenschichten (5a, 5b) einen Aluminiumgehalt x haben, für den 0,03 < x ≤ 0,5 gilt,
- die Zwischenschichten (5a, 5b) je eine Dicke (T) zwischen einschließlich 15 nm und 250 nm aufweisen, und
- die Zwischenschichten (5a, 5b) je eine spezifische Chemikaliendurchlässigkeit gegenüber Salpetersäure aufweisen, die geringer ist als die für die an die Zwischenschichten (5a, 5b) angrenzenden Schichten der Halbleiterschichtenfolge (1).

2. Optoelektronischer Halbleiterchip (100) nach dem vorhergehenden Anspruch,
bei dem eine Dotierstoffkonzentration einer der Zwischenschichten (5a, 5b) zwischen einschließlich 4 x 10¹⁸ pro cm³ und 5 x 10¹⁹ pro cm³ liegt und ein Dotierstoff Si ist.

3. Optoelektronischer Halbleiterchip (100) nach einem der vorhergehenden Ansprüche,
bei dem 0,03 ≤ x ≤ 0,5 gilt.

4. Optoelektronischer Halbleiterchip (100) nach einem der vorhergehenden Ansprüche,
bei dem eine auf GaN basierende, mindestens mit einer Dotierstoffkonzentration von 5 x 10¹⁸ pro cm³ n-dotierte Stromaufweitungsschicht (7) der n-dotierten Schichtenfolge (4) sich zwischen der Zwischenschicht (5a) und der weiteren Zwischenschicht (5b) befindet und unmittelbar an diese grenzt.

5. Optoelektronischer Halbleiterchip (100) nach einem der vorhergehenden Ansprüche,
bei dem eine Gesamtdicke (G) der Halbleiterschichtenfolge (1) zwischen einschließlich 1,0 µm und 10,0 µm liegt.

## Claims

1. Optoelectronic semiconductor chip (100) with an epitaxially grown semiconductor layer sequence (1) based on GaN, InGaN, AlGaN or InAlGaN, comprising:
- a p-doped layer sequence (2),
- an n-doped layer sequence (4),
- an active zone (3) which is configured for generating an electromagnetic radiation and which is located between the p-doped layer sequence (2) and the n-doped layer sequence (4), and
- two intermediate layers (5a, 5b) based on AlₓGa₁₋ₓN and located on the same side of the active zone (3) such as the n-doped layer sequence (4) and adjoining on both sides to GaN layers which have no Al content,
wherein
- a first one of the intermediate layers (5a) is an uninterrupted, continuous layer,
- a second one of the intermediate layers (5b) is arranged between the first one of the intermediate layers (5a) and the active zone (3) and at least one electrical through-connection (10) runs through the active zone (3) and the second one of the intermediate layers (5b) so that all electric contacts for supplying current to the semiconductor chip (100) are located on only one side of the active zone (3), and
there is no current flow through the first one of the intermediate layers (5a) so that the active zone (3) is supplied with current not through the first one of the intermediate layers (5a), whereas a flow of current through the second one of the intermediate layers (5b) takes place,
**characterized in that**
- the semiconductor layer sequence (1) comprises exactly two of the intermediate layers (5a, 5b) based on AlₓGa₁₋ₓN,
- the intermediate layers (5a, 5b) based on AlₓGa₁₋ₓN have an aluminum content x for which 0.03 < x ≤ 0.5 applies,
- the intermediate layers (5a, 5b) each have a thickness (T) of between 15 nm and 250 nm inclusive, and
- the intermediate layers (5a, 5b) each have a specific chemical permeability to nitric acid which is lower than for layers of the semiconductor layer sequence (1) adjoining the intermediate layers (5a, 5b).

2. The optoelectronic semiconductor chip (100) according to the preceding claim,
in which a dopant concentration of one of the intermediate layers (5a, 5b) is between 4 x 10¹⁸ per cm³ and 5 x 10¹⁹ per cm³ inclusive and is a dopant Si.

3. The optoelectronic semiconductor chip (100) according to one of the preceding claims,
wherein 0.03 ≦ x ≦ 0.5 applies.

4. The optoelectronic semiconductor chip (100) according to one of the preceding claims,
wherein an n-doped current spreading layer (7) of the n-doped layer sequence (4) having a dopant concentration of at least 5 x 10¹⁸ per cm³ is located between the intermediate layer (5a) and the further intermediate layer (5b) and directly adjoins the intermediate layers (5a, 5b).

5. The optoelectronic semiconductor chip (100) according to one of the preceding claims,
in which a total thickness (G) of the semiconductor layer sequence (1) is between 1.0 µm and 10.0 µm inclusive.

## Revendications

1. Puce optoélectronique à semiconducteur (100) avec une succession de couches à semiconducteur (1) à croissance épitaxiale se basant sur AlGaN ou InAlGaN, qui présente :
- une succession de couches dopée en p (2),
- une succession de couches dopée en n (4),
- une zone active (3), qui est prévue pour la production d'un rayonnement électromagnétique et qui se trouve entre la succession de couches dopée en p (2) et la succession de couches dopée en n (4), et
- deux couches intermédiaires se basant sur AlₓGa₁₋ₓN (5a, 5b), qui se trouvent sur le même côté de la zone active (3) que la succession de couches dopée en n (4) et qui jouxtent des deux côtés respectivement des couches de GaN, qui ne présentent aucune part d'Al,
sachant que
- une première des couches intermédiaires (5a) est une couche continue ininterrompue,
- une seconde des couches intermédiaires (5b) est disposée entre la première couche intermédiaire (5a) et la zone active (3) et au moins un trou d'interconnexion électrique (10) pénètre la zone active (3) et la seconde couche intermédiaire (5b) de sorte que toutes les mises en contact électrique se trouvent uniquement sur un côté de la zone active (3) en vue de l'alimentation en courant de la puce à semiconducteur (100), et
via la première des couches intermédiaires (5a) n'a lieu aucune circulation de courant, de sorte qu'une alimentation en courant de la zone active (3) ne s'effectue pas via la première des couches intermédiaires (5a), tandis qu'un flux de courant s'effectue à travers la seconde des couches intermédiaires (5b),
**caractérisée en ce que**
- la succession de couches à semiconducteur (1) présente exactement deux couches intermédiaires (5a, 5b) se basant sur AlₓGa₁₋ₓN,
- les couches intermédiaires (5a, 5b) se basant sur AlₓGa₁₋ₓN possèdent un taux d'aluminium x pour lequel s'applique 0,03 ≤ x ≤ 0,5,
- les couches intermédiaires (5a, 5b) présentent respectivement une épaisseur (T) entre 15 nm et 250 nm inclus, et
- les couches intermédiaires (5a, 5b) présentent respectivement une perméabilité spécifique des substances chimiques à l'acide nitrique, qui est plus basse que celle pour les couches jouxtant les couches intermédiaires (5a, 5b) de la succession de couches à semiconducteur (1).

2. Puce optoélectronique à semiconducteur (100) selon la revendication précédente,
pour laquelle une concentration d'agent de dopage d'une des couches intermédiaires (5a, 5b) se trouve respectivement à entre 4 x 10¹⁸ par cm³ et 5 x 10¹⁹ par cm³ inclus et est un agent de dopage Si.

3. Puce optoélectronique à semiconducteur (100) selon une quelconque des revendications précédentes,
pour laquelle s'applique 0,03 ≤ x ≤ 0,5.

4. Puce optoélectronique à semiconducteur (100) selon une quelconque des revendications précédentes,
pour laquelle une couche d'expansion du courant dopée en n (7) de la succession de couches dopées en n (4) avec au moins une concentration d'agent de dopage de 5 x 10¹⁸ par cm³ se trouve entre la couche intermédiaire (5a) et l'autre couche intermédiaire (5b) et jouxte directement celle-ci.

5. Puce optoélectronique à semiconducteur (100) selon une quelconque des revendications précédentes,
pour laquelle une épaisseur totale (G) de la succession de couches à semiconducteur (1) se trouve entre 1,0 µm et 10,0 µm inclus.
